# EUROPEAN PATENT APPLICATION

(11) **EP 4 060 832 A1**
(43) Date of publication of application: **21.09.2022**
(21) Application number: 21162988.6
(22) Date of filing: 16.03.2021
(51) Int. Cl.: H01S 5/026, H01L 33/06, G02F 1/39, H01S 5/10

(54) **RADIATION EMITTER AND METHOD OF FABRICATING A RADIATION EMITTER**

(71) Applicant: Technische Universität Berlin, 10623 Berlin (DE)
(72) Inventor: REITZENSTEIN, Stephan, 14089 Berlin (DE)
(74) Representative: Fischer, Uwe

(57) **Abstract**

The invention inter alia relates to radiation emitter (100) comprising an emitter section (120) and an optical pump section (110) that is capable of generating pump radiation (Rp) in order to excite the emitter section (120) to emit single photons (P) or entangled photon pairs. The optical pump section (110) is ring-shaped and the emitter section (120) is located inside the ring-shaped pump section (110).

## Description

The invention relates to radiation emitters capable of emitting single photons or entangled photon pairs during operation.

### Background of the invention

The publication "Electrically Tunable Single-Photon Source Triggered by a Monolithically Integrated Quantum Dot Microlaser" (Pierce Munnelly, Tobias Heindel, Alexander Thoma, Martin Kamp, Sven Holing, Christian Schneider, and Stephan Reitzenstein; American Chemical Society ACS Photonics 2017, 4, 790-794, DOI: 10.1021/acsphotonics.7b00119) discloses a radiation emitter which comprise the features of the preamble of claim 1. The radiation emitter according to the publication comprises an emitter section and an optical pump section. The pump section is capable of generating pump radiation in order to excite the emitter section. In response to excitation, the emitter section emits single photons or entangled photon pairs. The pump section and the emitter section are each integrated in a pillar. The pillars are disposed on the same substrate and are oriented parallel to each other, thereby forming an arrangement of two parallel pillars.

### Objective of the present invention

An objective of the present invention is to provide a radiation emitter that is optimized with respect to adapting the wavelength of the pump section to the optimal excitation wavelength needed by the emitter section.

Another objective of the present invention is to provide a method of fabricating a radiation emitter that is optimized with respect to adapting the wavelength of the pump section to the optimal excitation wavelength needed by the emitter section.

### Brief summary of the invention

An embodiment of the present invention relates to a radiation emitter comprising an emitter section and an optical pump section that is capable of generating pump radiation in order to excite the emitter section to emit single photons or entangled photon pairs, wherein the optical pump section is ring-shaped and the emitter section is located inside the ring-shaped pump section.

An advantage of this embodiment of the invention is that the ring-shaped pump section provides an additional design parameter that can be used to properly adapt the wavelength of the pump radiation to the demands of the emitter section in order to make sure that electrical trigger signals applied to the pump section will lead to the generation of a single photon or a single entangled photon pair by the emitter section.

An outer ring wall of the ring-shaped pump section preferably acts as an internal reflection wall and defines whispering gallery modes of the pump radiation that circulates inside the ring-shaped pump section.

The wavelength of at least one of the whispering gallery modes preferably leads to optical excitation of the emitter section. To this end, for instance, the wavelength of at least one of the whispering gallery modes preferably corresponds to the resonance wavelength of the emitter section.

An inner ring wall of the ring-shaped pump section preferably comprises at least one radial defect (e. g. protrusion or indentation) that protrudes radially outwards (i.e. into the ring of the ring-shaped pump section) or radially inwards (i.e. towards the emitter section) and leaks optical pump radiation towards the emitter section.

The pump section may include a pin-diode structure that allows activating the pump section by injecting an electrical current or current pulse.

The optical pump section preferably comprises a ring-shaped layer stack. The ring-shaped layer stack preferably forms a pin-diode structure comprising a p-doped layer, an n-doped layer and an active layer between the n-doped layer and the p-doped layer.

According to an exemplary embodiment, the emitter section and the ring-shaped pump section share a common active layer that has been deposited during fabrication. The emitter section may comprise a quantum emitter (e.g. a quantum dot) that is located in the common active layer, and the ring-shaped pump section may comprise a plurality of quantum dots that are also located in the common active layer.

According to another exemplary embodiment, the emitter section comprises a quantum emitter (e.g. a quantum dot) that is located in an active layer, and the ring-shaped pump section comprises a quantum film or a plurality of quantum dots that are located in another active layer.

The pump section is preferably circularly shaped. The emitter section is preferably located in the center of the circularly shaped pump section.

A Bragg resonator is preferably located radially between the ring-shaped pump section and the emitter section.

The Bragg resonator preferably comprises a plurality of concentric circular rings. The Bragg resonator may direct photons emitted by the emitter section in a direction perpendicular to the ring plane of the ring-shaped pump section.

The substrate preferably comprises a mirror that is located beneath the emitter section. The mirror may reflect photons emitted by the emitter section towards an exit plane above the emitter section.

The radiation emitter may further comprise a piezo element capable of applying mechanical strain to the emitter section. The strain preferably influences the emission wavelength of the emitter section and/or the resonance wavelength of the emitter section. The resonance wavelength describes the wavelength of pump radiation that is capable of exciting the emitter section to emit photons or entangled photon pairs.

A control device is preferably connected to the piezo element. The control device may be configured to control the piezo element to generate an amount of strain that causes the resonance wavelength of the emitter section to match at least one of the whispering gallery modes of the pump section. Alternatively or additionally, the radiation emitter may comprise a temperature influencing unit (such as a heater for instance) that may influence the temperature of the emitter section and therefore the emission wavelength of the emitter section and/or the resonance wavelength of the emitter section.

A control device is preferably connected to the temperature influencing unit. The control device may be configured to control the temperature influencing unit to provide a temperature that causes the resonance wavelength of the emitter section to match at least one of the whispering gallery modes of the pump section.

Another embodiment of the present invention relates to a method of fabricating a radiation emitter comprising the steps of fabricating an emitter section and an optical pump section that is capable of generating pump radiation in order to excite the emitter section to emit single photons or entangled photon pairs. Said step of fabricating the pump section includes forming a ring around the emitter section.

The step of fabricating the pump section preferably includes providing an outer ring wall that acts as an internal reflection wall and defines whispering gallery modes of the pump radiation that circulates inside the ring-shaped pump section.

The diameter of the outer ring wall may be chosen such that the wavelength of at least one of the whispering gallery modes leads to optical excitation of the emitter section. At least one of the whispering gallery modes preferably corresponds to the resonance wavelength of the emitter section. The step of fabricating the pump section may further include fabricating at least one radial defect, that protrudes radially outwards towards the ring-shaped pump section or inwards towards the emitter section. The radial defect preferably leaks optical pump radiation towards the emitter section.

### Brief description of the drawings

In order that the manner in which the above-recited and other advantages of the invention are obtained will be readily understood, a more particular description of the invention briefly described above will be rendered by reference to specific embodiments thereof which are illustrated in the appended drawings. Understanding that these drawings depict only typical embodiments of the invention and are therefore not to be considered to be limiting of its scope, the invention will be described and explained with additional specificity and detail by the use of the accompanying drawings in which
- Figures 1-3: illustrate method steps for fabricating a first exemplary embodiment of a radiation emitter according to the present invention,
- Figure 4: illustrates a top view of the first exemplary embodiment,
- Figure 5: illustrates whispering gallery modes in the pump section of the first exemplary embodiment during operation,
- Figure 6: illustrates a cross-section of the first exemplary embodiment during operation,
- Figure 7: illustrates a cross-section of a second exemplary embodiment of a radiation emitter according to the present invention, and
- Figure 8: illustrates a cross-section of a third exemplary embodiment of a radiation emitter according to the present invention.

### Detailed description of the preferred embodiments

The preferred embodiments of the present invention will be best understood by reference to the drawings. It will be readily understood that the present invention, as generally described and illustrated in the figures herein, could vary in a wide range. Thus, the following more detailed description of the exemplary embodiments of the present invention, as represented in the figures, is not intended to limit the scope of the invention, as claimed, but is merely representative of presently preferred embodiments of the invention.

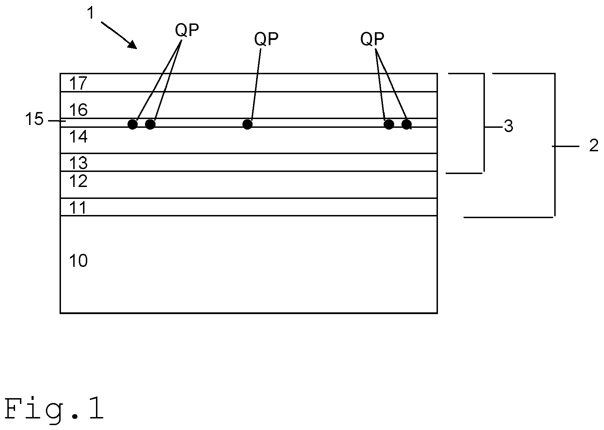

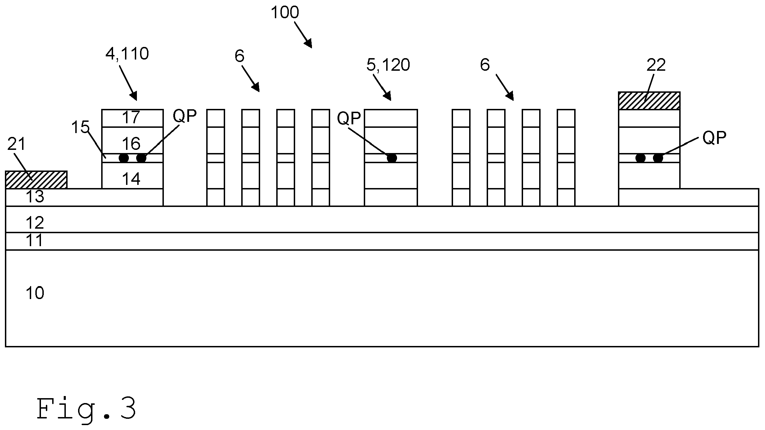

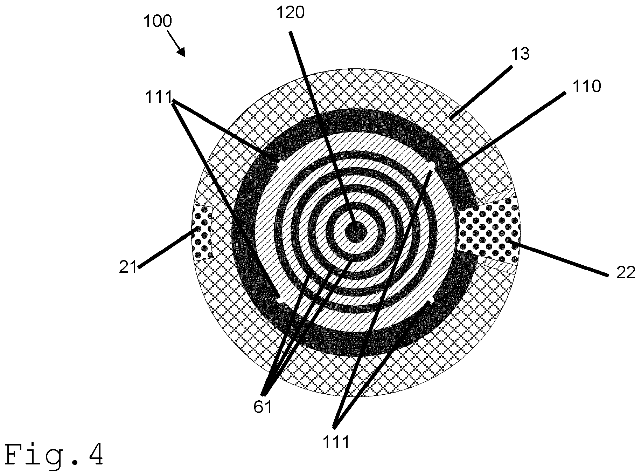

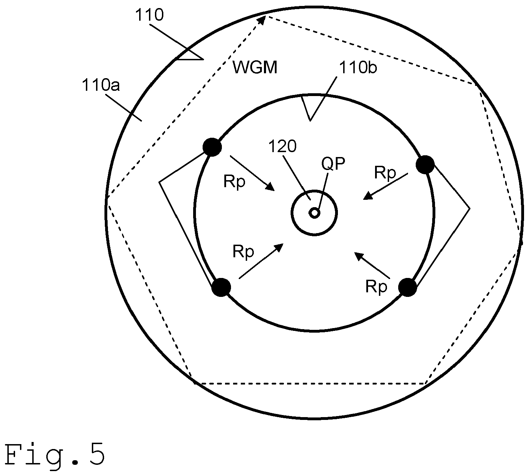

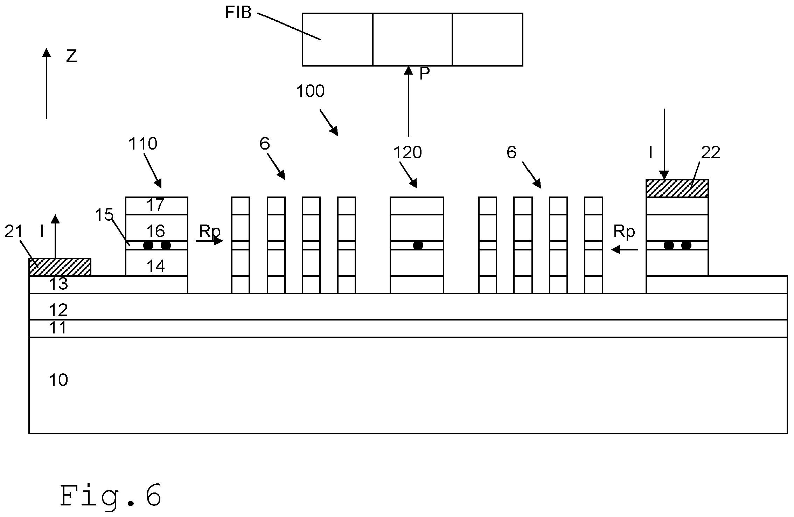

In connection with Figures 1-3, exemplary method steps will be explained which yield an exemplary embodiment of a radiation emitter according to the present invention. Figures 3-6 show the resulting radiation emitter 100. Figures 3 and 6 depict a cross-section. Figures 4 and 5 depict a top-view.

Figure 1 shows a cross-section of a layer structure 1 which has been fabricated by depositing a layer stack 2 of layers on a substrate 10.

The layer stack 2 comprises a mirror 11 that may consist of a single layer or a stack of mirror layers. For instance, the mirror 11 may consist of a gold or silver layer. Alternatively, the mirror 11 may be formed by a stack of sublayers, for instance semiconductor layers, which together provide a distributed Bragg reflector (DBR).

The layer stack 2 further comprises a dielectric layer 12 which is transparent for the radiation emitted by the emitter section 120 of the radiation emitter 100 (see Figures 3-6). The dielectric layer 12 is electrically insulating and separates the mirror 11 from a pin-diode structure 3 that is deposited on top of the dielectric layer 12.

In the exemplary embodiment of Figures 1-3, the pin-diode structure 3 comprises an n-doped layer 13, a first undoped layer 14, an undoped active layer 15, a second undoped layer 16 and a p-doped layer 17 on top.

During the fabrication of the active layer 15, a single quantum dot QP is manufactured in a center area 5 which will be part of the emitter section 120 of the radiation emitter 100 (see Figures 3-6). Moreover, a plurality of quantum dots QP is arranged in another area which will be part of the ring-shaped pump section 110 of the radiation emitter 100. In the embodiment of Figures 1-6, the emitter section 120 and the ring-shaped pump section 110 share the same common active layer 15.

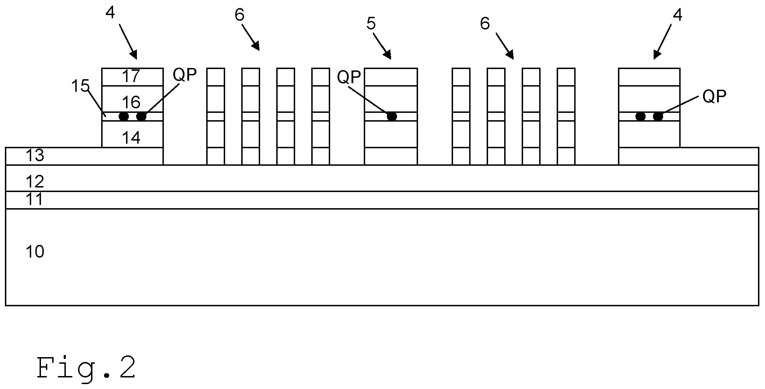

Figure 2 shows the layer structure 1 of Figure 1 after locally removing the layers 13-17 of the pin-diode structure 3. Outside a ring 4, only the first undoped layer 14, the active layer 15, the second undopded layer 16 and the p-doped layer 17 are removed whereas the n-doped layer 13 remains unaffected (at least in areas dedicated to a future n-contact 21, see Figures 3 and 6). The ring 4 forms the ring-shaped pump section 110 of the radiation emitter 100 (see Figures 3-6).

In addition to the outer ring 4, said step of locally removing the pin-diode structure 3 provides a center section 5 that forms the emitter section 120 of the radiation emitter 100 (see Figures 3-6), as well as a Bragg resonator 6 that is located radially between the ring 4 and the center section 5. The Bragg resonator 6 comprises a plurality of concentric circular rings 61 (see Figure 4) and acts as a lateral lens. The lens directs photons emitted by the emitter section 120 in a direction perpendicular to the ring plane of the ring-shaped pump section 110 (see vertical axis Z in Figure 6).

Figure 3 shows the resulting layer structure and the completed radiation emitter 100 after depositing an n-contact 21 and a p-contact 22 on top of the n-doped layer 13 and the p-doped layer 17, respectively. The contacts 21 and 22 allow injecting electrical current pulses I into the pin-diode structure 3 in order to activate the pump section 110 of the radiation emitter 100.

Figure 4 shows the top-view of the completed radiation emitter 100 of Figure 3. The inner ring wall 110b (see Figure 5) of the ring-shaped pump section 110 comprises four radial defects 111 in form of indentations 111 that protrude radially outwards. The radial defects 111 - during operation - leak optical pump radiation Rp towards the emitter section 120.

Figure 5 shows a simplified top-view of the radiation emitter 100 of Figures 3 and 4. The outer ring wall 110a of the ring-shaped pump section 110 acts as an internal reflection wall that defines whispering gallery modes WGM of the pump radiation Rp that circulates inside the ring-shaped pump section 110. The diameter of the outer ring wall 110a determines the wavelength of the whispering gallery modes WGM and therefore the wavelength of the radiation Rp that is leaked by the radial defects 111 towards the emitter section. The diameter therefore provides a design parameter that can be optimized to influence the wavelength of the pump radiation Rp that is sent to the inner emitter section 120.

Figure 6 shows the radiation emitter 100 of Figures 3-5 during operation. Upon activation of the pump section 110 by injecting an electric current pulse I into the pin-diode structure 3, pump radiation Rp is leaked towards the inner emitter section 120. The pump radiation Rp triggers the inner emitter section 120 to generate a single photon P or a pair of entangled photons P. The emitted photons P are directed in a direction perpendicular to the ring plane of the ring-shaped pump section 120 and may be coupled into a fiber FIB mounted above the emitter section 120.

The direction of the emitted photons P is influenced by the backside reflection of the mirror 11 which vertically reflects the photons P towards an exit plane above the quantum dot Q.

The direction of the emitted photons P is further influenced by the Bragg resonator 6 which surrounds the inner quantum dot QP and functions as a lateral optical lens. The Bragg resonator 6 avoids a lateral emission in the horizontal direction in Figure 6.

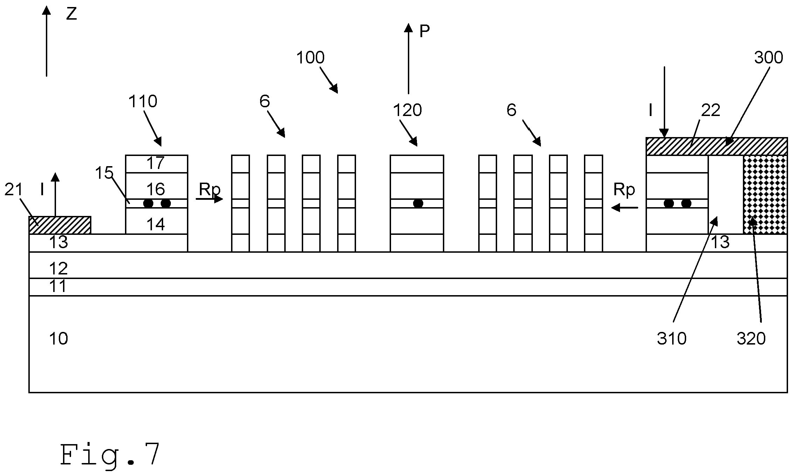

Figure 7 depicts a second exemplary embodiment of a radiation emitter 100 according to the present invention. The p-contact 22 and a pillar 320 of dielectric material form a bridge 300 above a trench 310. The other features described in connection with the first exemplary embodiment according to Figures 1-6 are the same.

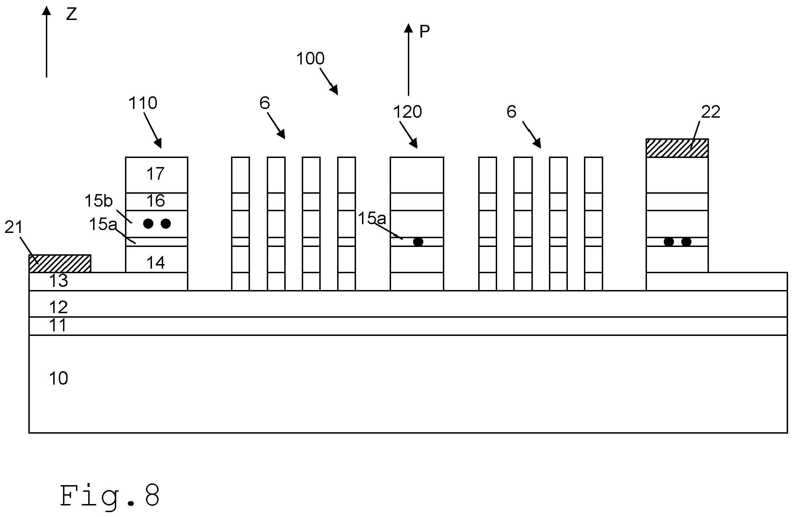

Figure 8 depicts a third exemplary embodiment of a radiation emitter 100 according to the present invention. The radiation emitter of Figure 8 comprises a modified pin-diode structure. The pin-diode structure of Figure 8 comprises two active layers 15a and 15b instead of a single active layer.

During the fabrication of the active layer 15a, a single quantum dot QP is manufactured in the emitter section 120 of the radiation emitter 100. During the fabrication of the active layer 15b, a plurality of quantum dots QP is manufactured in the ring-shaped pump section 110 of the radiation emitter 100. As a result, the emitter section 120 and the ring-shaped pump section 110 each have an individually assigned active layer 15a and 15b, respectively.

In the exemplary embodiment of Figure 8 the active layer 15b, which comprises the quantum dots of the ring-shaped pump section 110, is directly located above the active layer 15a, which comprises the single quantum dot of the emitter section 120. Alternatively, the active layer 15b may be located below the active layer 15a. Furthermore, regardless of which layer 13a or 13b is on top of the other, the layers 13a and 13b may be separated by one or more intermediate layers.

In the exemplary embodiments described above with reference to Figures 1-8, the substrate may comprise or consist of a piezo element that may apply mechanical strain to the emitter section 120. A control device preferably controls the piezo element to generate an amount of strain that causes the resonance wavelength of the emitter section 120 to match at least one of the whispering gallery modes WGM of the pump section 110.

Alternatively or additionally, the radiation emitter 100 may comprise a temperature influencing unit (such as a heater for instance) that influences the temperature of the emitter section 120 and therefore the emission wavelength of the emitter section and/or the resonance wavelength of the emitter section. A control device preferably controls the temperature influencing unit to provide a temperature that causes the resonance wavelength of the emitter section to match at least one of the whispering gallery modes WGM of the pump section 110.

The various embodiments and aspects of embodiments of the invention disclosed herein are to be understood not only in the order and context specifically described in this specification, but to include any order and any combination thereof. Whenever the context requires, all words used in the singular number shall be deemed to include the plural and vice versa. Whenever the context requires, all options that are listed with the word "and" shall be deemed to include the world "or" and vice versa, and any combination thereof.

In the drawings and specification, there have been disclosed a plurality of embodiments of the present invention. The applicant would like to emphasize that each feature of each embodiment may be combined with or added to any other of the embodiments in order to modify the respective embodiment and create additional embodiments. These additional embodiments form a part of the present disclosure and, therefore, the applicant may file further patent claims regarding these additional embodiments at a later stage of the prosecution.

Further, the applicant would like to emphasize that each feature of each of the following dependent claims may be combined with any of the present independent claims as well as with any other (one or more) of the present dependent claims (regardless of the present claim structure). Therefore, the applicant may direct further patent claims towards other claim combinations at a later stage of the prosecution.

## Claims

1. Radiation emitter (100) comprising an emitter section (120) and an optical pump section (110) that is capable of generating pump radiation (Rp) in order to excite the emitter section (120) to emit single photons (P) or entangled photon pairs,
**characterized in that**
the optical pump section (110) is ring-shaped and the emitter section (120) is located inside the ring-shaped pump section (110) .

2. Radiation emitter (100) according to claim 1, **characterized in that**
- an outer ring wall (110a) of the ring-shaped pump section (110) acts as an internal reflection wall and defines whispering gallery modes (WGM) of the pump radiation (Rp) that circulates inside the ring-shaped pump section (110),
- wherein the wavelength of at least one of the whispering gallery modes (WGM) leads to optical excitation of the emitter section (120) and/or corresponds to the resonance wavelength of the emitter section (120).

3. Radiation emitter (100) according to any of the preceding claims,
**characterized in that**
an inner ring wall (110b) of the ring-shaped pump section (110) comprises at least one radial defect (111), that protrudes radially outwards or inwards and leaks optical pump radiation (Rp) towards the emitter section (120).

4. Radiation emitter (100) according to any of the preceding claims,
**characterized in that**
the pump section (110) includes a pin-diode structure (3) that allows activating the pump section (110) by injecting an electrical current.

5. Radiation emitter (100) according to any of the preceding claims,
**characterized in that**
- the optical pump section (110) comprises a ring-shaped layer stack,
- wherein said ring-shaped layer stack forms a pin-diode structure (3) that comprises a p-doped layer, an n-doped layer and an active layer between the n-doped layer and the p-doped layer.

6. Radiation emitter (100) according to any of the preceding claims,
**characterized in that**
- the emitter section (120) and the ring-shaped pump section (110) share a common active layer (15),
- wherein the emitter section (120) comprises a quantum emitter that is located in said common active layer, and
- wherein the ring-shaped pump section (110) comprises a plurality of quantum dots that are located in said same common active layer (15).

7. Radiation emitter (100) according to any of the preceding claims 1 - 5,
**characterized in that**
- wherein the emitter section (120) comprises a quantum emitter that is located in an active layer (15a), and
- wherein the ring-shaped pump section (110) comprises a quantum film or a plurality of quantum dots that are located in another active layer (15b).

8. Radiation emitter (100) according to any of the preceding claims,
**characterized in that**
- the pump section (110) is circularly shaped, and
- the emitter section (120) is located in the center of the circularly shaped pump section (110).

9. Radiation emitter (100) according to any of the preceding claims,
**characterized in that**
- a Bragg resonator (6) is located radially between the ring-shaped pump section (110) and the emitter section (120),
- wherein said Bragg resonator (6) comprises a plurality of concentric rings and directs photons (P) emitted by the emitter section (120) in a direction perpendicular to the ring plane of the ring-shaped pump section (110).

10. Radiation emitter (100) according to any of the preceding claims,
**characterized in that**
- the substrate comprises a mirror (11) that is located beneath the emitter section (120) and
- the mirror reflects photons (P) emitted by the emitter section (120) towards an exit plane above the emitter section (120).

11. Radiation emitter (100) according to any of the preceding claims,
**characterized in that**
- the radiation emitter (100) comprises a piezo element capable of applying mechanical strain to the emitter section (120), and/or a temperature influencing unit capable of modifying the temperature of the emitter section (120),
- wherein a control device is connected to the piezo element and/or the temperature influencing unit and controls the piezo element and/or the temperature influencing unit to generate an amount of strain and/or provide a device temperature that causes the resonance wavelength of the emitter section (120) to match at least one of the whispering gallery modes (WGM) of the pump section (110).

12. Method of fabricating a radiation emitter (100) comprising the steps of fabricating an emitter section (120) and an optical pump section (110) that is capable of generating pump radiation (Rp) in order to excite the emitter section (120) to emit single photons (P) or entangled photon pairs,
**characterized in that**
said step of fabricating the pump section (110) includes forming a ring around the emitter section (120).

13. Method emitter according to claim 12,
**characterized in that**
- said step of fabricating the pump section (110) includes providing an outer ring wall (110a) that acts as an internal reflection wall and defines whispering gallery modes (WGM) of the pump radiation (Rp) that circulates inside the ring-shaped pump section (110),
- wherein the diameter of the outer ring wall (110a) is chosen such that the wavelength of at least one of the whispering gallery modes (WGM) leads to optical excitation of the emitter section (120) and/or corresponds to the resonance wavelength of the emitter section (120).

14. Method emitter according to any of the preceding claims 12-13,
**characterized in that**
said step of fabricating the pump section (110) includes fabricating at least one radial defect (111), that protrudes radially inwards or outwards and leaks optical pump radiation (Rp) towards the emitter section (120).
